Europäisches Patentamt

**European Patent Office**

Office européen des brevets

(11) Numéro de publication: **0 028 170**
**A1**

## (12) DEMANDE DE BREVET EUROPEEN

(21) Numéro de dépôt: **80401364.7**

(22) Date de dépôt: **25.09.80**

(51) Int. Cl.³: **H 01 L 21/56**, H 01 L 23/28

(30) Priorité: **05.10.79 FR 7924894**

(71) Demandeur: **THOMSON-CSF, 173, Boulevard Haussmann, F-75360 Paris Cedex 08 (FR)**

(43) Date de publication de la demande: **06.05.81 Bulletin 81/18**

(72) Inventeur: **Peyre-Lavigne, André, "THOMSON-CSF" SCPI 173, Bld. Haussmann, F-75360 Paris Cedex 08 (FR)**

(74) Mandataire: **de Beaumont, Michel et al, "THOMSON-CSF" SCPI 173, Bld Haussmann, F-75360 Paris Cedex 08 (FR)**

(84) Etats contractants désignés: **DE FR GB IT NL**

(54) **Procédé de sillonnage et de glassivation par masquage au nitrure de silicium et composants semiconducteurs obtenus.**

(57) La présente invention concerne un procédé de sillonnage et de glassivation par masquage au nitrure de silicium et des composants semiconducteurs obtenus.

Etant donné une palquette semiconductrice (23) délimitée latéralement par un sillon (30), la face supérieure de cette plaquette est recouverte par une couche de nitrure de silicium (22) faisant saillie par rapport à la face principale de la plaquette. La glassivation (40) déposée dans le sillon et au-dessus de la face vers la limite de l'arête mouille la languette de nitrure de silicium en débordement et assure ainsi une bonne protection des arêtes de la plaquette.

Application aux composants semiconducteurs de puissance et notamment aux transistors.

EP 0 028 170 A1

ACTORUM AG

# PROCEDE DE SILLONNAGE ET DE GLASSIVATION PAR
## MASQUAGE AU NITRURE DE SILICIUM ET
### COMPOSANTS SEMICONDUCTEURS OBTENUS

La présente invention concerne un procédé de sillonnage et de passivation et les composants semiconducteurs obtenus.

Dans la technique de fabrication des composants semiconducteurs, on part généralement d'une plaquette semiconductrice qui subit selon un motif répétitif divers traitements. Ensuite, les motifs élémentaires sont isolés par des sillons puis une découpe est effectuée selon les sillons pour fournir des composants élémentaires.

Il importe de déposer des agents de protection, couramment appelés de passivation, sur les faces latérales des composants discrets, notamment au niveau des affleurements de jonction. Cette passivation a d'une part pour rôle de protéger les faces latérales du composant contre des produits contaminants, d'autre part (essentiellement pour les composants fonctionnant à tension élevée), un rôle électrique pour favoriser la distribution des lignes de champ à la limite latérale du composant, et éviter, comme cela est bien connu, qu'il ne se produise des claquages superficiels avant les claquages en volume utiles au bon fonctionnement du composant. Il est bien entendu souhaitable d'effectuer le revêtement de passivation latéral avant de découper complètement la plaquette en pavés élémentaires, le traitement individuel de ces pavés élémentaires de très petites dimensions étant fort délicat.

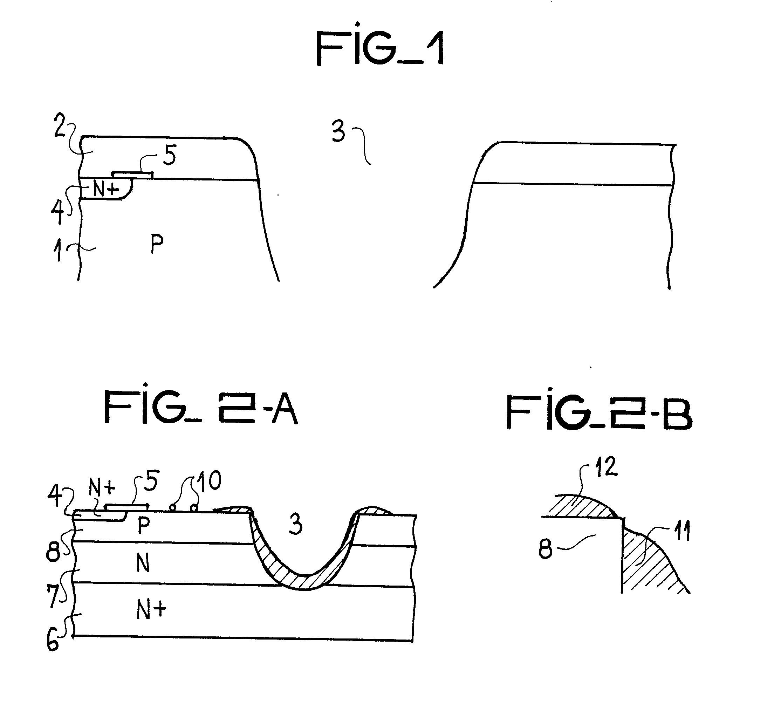

L'un des procédés de l'art antérieur permettant de réaliser un sillonnage et une passivation de la zone sillonnée va être rappelé ci-dessous en relation avec les figures 1, 2A et 2B.

La figure 1 représente une partie de la zone supérieure d'une plaquette 1. Pour effectuer un sillon, on recouvre cette plaquette d'une couche 2 de résine photosensible (par exemple du type disponible sous l'appellation Waycoat). Cette couche de résine 2 est ouverte aux emplacements où l'on souhaite effectuer le sillon et un sillon 3 est formé par attaque chimique. Cette attaque chimique prend place d'une part verticalement perpendiculairement à la face principale de la plaquette, d'autre part latéralement. Pendant cette extension latérale, le produit d'attaque élimine également la couche de Waycoat déposée sur la partie de la plaquette qui est attaquée. On obtient donc une structure sensiblement telle que représentée en figure 1. On a également représenté en figure 1 un affleurement d'une couche de type planar 4, protégé par une couche de silice 5.

Une fois le sillon formé, la couche de résine photosensible 2 est enlevée et une couche d'un mélange contenant des billes de verre dans un liant est déposée sur la structure. On peut ou bien déposer ce mélange uniformément, évacuer le liant par action thermique, et fritter le verre pour former une couche uniforme à la fois sur toute la surface de la plaquette et dans les sillons, puis découper ensuite par masquage et attaque chimique le verre pour le maintenir uniquement dans les sillons et sur la surface de la plaquette au voisinage de ces sillons ; ou bien utiliser comme liant une résine photosensible et éliminer par masquage, éclairement et dissolution la couche de mélange de verre aux emplacements où on ne souhaite pas la déposer puis, après seulement, évacuer le liant par action thermique et fritter le verre.

Cet ensemble d'étapes de l'art antérieur présente quatre inconvénients notables.

Le premier est que les couches de résine généralement utilisées sont peu transparentes et que l'alignement du masque d'ouverture de la résine pour délimiter les zones de sillonnage est difficile à faire en corrélation avec l'emplacement des motifs élémentaires antérieurs.

Le deuxième inconvénient réside dans le fait qu'au bout d'une certaine durée d'attaque, le produit attaquant le silicium pour former le sillon 3 attaque également la couche de résine protectrice 2. Ce phénomène se produit notamment à la limite du sillon et il se produit un décollement de la couche de résine. On est ainsi limité en profondeur d'attaque chimique à des valeurs de l'ordre de la soixantaine de microns.

Les troisième et quatrième inconvénients vont être illustrés en relation avec les figures 2A et 2B. Ces figures représentent à titre d'exemple une plaquette de silicium polycristallin dans laquelle on a formé une structure de transistors et qui comprend une couche 6 de type $N^+$, une couche 7 de type N, une couche 8 de type P, la couche 4 de type $N^+$ déjà représentée en figure 1, et la couche de silice 5 déjà représentée en figure 1 passivant en surface l'affleurement de la jonction entre les couches 4 et 8. Après frittage, dans le cas où l'on a initialement localisé le mélange verre/liant, on obtient une structure comprenant une couche de verre fritté 9 et éventuellement, mais fréquemment, des gouttelettes de verre projetées lors du frittage et désignées par la référence 10 (dans le cas où le dépôt de verre n'a pas été localisé, la couche de verre 9 s'étend uniformément sur toute la surface de la plaquette).

Le troisième inconvénient des techniques de l'art antérieur est illustré en figure 2B qui représente de façon agrandie un coin supérieur du sillon. La couche de verre peut ne pas recouvrir uniformément ce coin qui peut se trouver exposé, et la couche de verre est divisée en une partie 11 recouvrant le sillon, et une partie 12 recouvrant une partie de la surface supérieure. On obtient ainsi, au voisinage du coin (qui est en fait une arête) un affleurement du silicium du composant semi-

4

conducteur. Lors des attaques ultérieures, cette partie de silicium peut être attaquée chimiquement et l'on conçoit les inconvénients que ceci peut apporter au fonctionnement de la structure.

Le quatrième inconvénient résulte ou bien de la présence des gouttelettes de projection 10, dans le cas où on a initialement localisé le dépôt du mélange de verre et de liant, ou bien de la présence d'une couche de verre continue sur toute la plaquette. Pour enlever ces gouttelettes ou cette couche de verre continue, les produits d'attaque efficaces comprennent essentiellement de l'acide fluorhydrique. Malencontreusement, cet acide attaque simultanément les couches de silice, telles que la couche de silice 5 passivant l'affleurement de la jonction entre les couches 4 et 8. Cet inconvénient, qui est mineur dans le cas de structures du type thyristor ou triac qui se satisfont de courts-circuits d'émetteur, est rédhibitoire dans le cas de structures du type transistor dans lesquelles cette couche de passivation 5 a une grande influence sur le fonctionnement du dispositif.

Ainsi, un objet de la présente invention est de prévoir un nouveau procédé de sillonnage d'une plaquette semiconductrice suivi d'une glassivation du sillon évitant notamment les quatre inconvénients de l'art antérieur mentionnés ci-dessus.

Un autre objet de la présente invention est de prévoir une nouvelle structure de composant semiconducteur glassivé latéralement mettant en oeuvre le procédé ci-dessus.

Ainsi, la présente invention prévoit un procédé de formation de sillons profonds dans une plaquette de silicium comprenant les étapes consistant à : - former sur la plaquette une couche mince de silice thermique d'une épaisseur comprise entre sensiblement 300 et 1000 Å ; - former sur cette couche de silice une couche de nitrure de silicium d'une épaisseur de 900 à 1500 Å ;

- former des sillons dans la plaquette ; -enlever les parties de la couche de nitrure restant éventuellement en surplomb au-dessus des sillons ; - procéder à une attaque chimique de courte durée pour approfondir les sillons et former en surplomb une casquette de nitrure de silicium de largeur choisie ; et déposer une substance de passivation sur la plaquette, c'est-à-dire sur la couche de nitrure et dans le sillon.

Comme dans l'art antérieur, la couche de passivation peut être localisée ou non avant frittage. Pour former les sillons dans la plaquette, on peut ou bien procéder par voie mécanique à l'aide d'une scie diamantée, ou bien ouvrir les couches de nitrure et de silice aux emplacements souhaités par masquage et attaque, puis former par attaque chimique les sillons dans la plaquette au niveau des ouvertures formées dans les couches de nitrure et de silice, ou bien encore procéder complémentairement par voie mécanique et par voie chimique.

Avec ce procédé, on pallie les quatre inconvénients des procédés de l'art antérieur exposés ci-dessus. En effet :

- La couche de nitrure de faible épaisseur est transparente. On peut donc aligner le masquage ou le rayage de façon simple sur les motifs précédemment formés dans la plaquette.

- Le nitrure de silicium résiste bien aux produits d'attaque du silicium et le sillon peut être formé par attaque chimique à une profondeur importante pouvant aller jusqu'à 200 microns.

- Comme on le verra plus en détail ci-après, au cours du frittage, le verre adhère par capillarité à la casquette de nitrure de silicium surplombant le sillon et ainsi les arêtes de la face supérieure de chaque pavé sont recouvertes de façon satisfaisantes par la glassivation.

- Les produits d'attaque du verre sont sélectifs vis à vis du nitrure, et l'on peut ainsi enlever des gouttelettes de verre ou un dépôt de verre uniforme sans attaquer le nitrure sousjacent et, par conséquent, les couches de silice de passivation de jonction qu'il recouvre.

La structure selon la présente invention se distingue notamment par le fait que, à l'intérieur de la glassivation, et en prolongement de la face d'où part la glassivation, est contenue une languette de nitrure de silicium débordant de la face supérieure en casquette.

Ces objets, caractéristiques et avantages ainsi que d'autres de la présente invention seront exposés plus en détail dans la description suivante de modes de réalisation particuliers faite en relation avec les figures jointes parmi lesquelles :

les figures 1, 2A et 2B sont destinées à illustrer un procédé de l'art antérieur décrit précédemment ; et

les figures 3 à 7 illustrent diverses étapes successives du procédé de sillonnage et de glassivation selon la présente invention.

On notera que, dans ces diverses figures, les dimensions relatives des diverses couches, régions et sillons ne sont absolument pas tracées à l'échelle à l'intérieur d'une même figure ni d'une figure à l'autre. Conformément à la pratique courante dans la représentation des couches semiconductrices, les diverses couches ont été dilatées selon les besoins pour mieux illustrer la description et faciliter sa compréhension. Pour les valeurs réelles des diverses dimensions, on se référera aux connaissances générales dans la technique ainsi qu'aux indications particulières données dans certains cas dans la présente description.

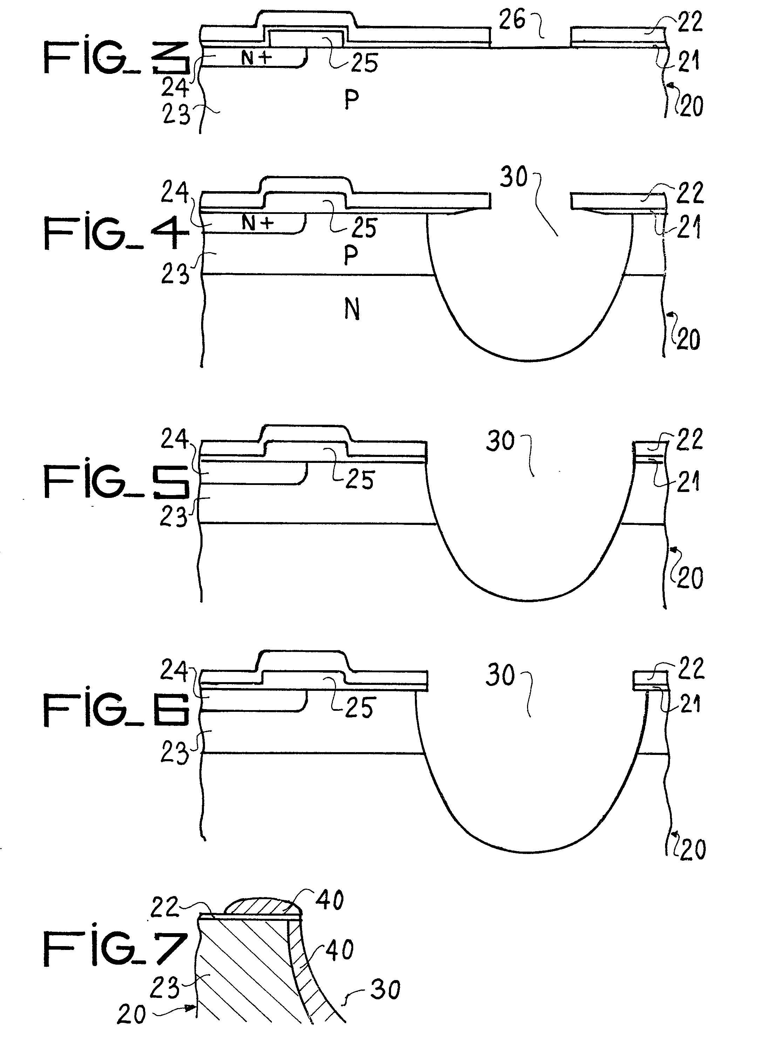

La figure 3 illustre une première étape du procédé selon la présente invention. Sur une plaquette de silicium 20 est d'abord formée une couche d'oxyde thermique 21 puis une couche de nitrure de silicium 22. La couche d'oxyde thermique a une épaisseur comprise entre 300 et 1000 Å, par exemple 500 Å. La couche de nitrure de silicium a une épaisseur comprise entre sensiblement 900 Å et sensiblement 1500 Å par exemple 1200 Å. On a représenté la plaquette de silicium 20 comme comprenant du côté de sa surface supérieure une couche 23 de type P dans laquelle est formée une région 24 de type N$^+$. La jonction entre les couches 23 et 24 affleure en surface et est protégée par un dépôt diélectrique 25, par exemple une couche de silice. Dans le cas où la couche 25 est une couche de silice, les couches 21 et 25 se fondent, comme cela est représenté dans les figures suivantes. L'ensemble des deux couches 21 et 22 est ouvert en un emplacement 26 par des procédés classiques (masquage et attaque au plasma pour la couche de nitrure de silicium 22 puis attaque chimique pour la couche de silice 21). On notera que la couche de silice 21 ne joue pas de rôle essentiel dans la présente invention, mais est décrite dans l'exemple donné car dans de nombreux cas pratiques elle présente une utilité notamment, lors des étapes d'enlèvement partiel de la couche de nitrure, une attaque au plasma n'affecte pas ou peu une couche de silice alors qu'elle affecterait une couche de silicium si le nitrure de silicium était déposé directement sur le silicium.

Dans l'étape suivante, illustrée en figure 4, le silicium 20 est  attaqué pour former un sillon 30. Pendant cette étape, la couche de nitrure 22 n'est pratiquement pas attaquée et il demeure des languettes de nitrure de silicium qui surplombent les deux parois latérales du sillon. Pour prendre des ordres de grandeur pratiques, en rappelant que la couche de nitrure a une épaisseur de l'ordre de 1000 Å, si le sillon a une profondeur de l'ordre de 100 microns, les languettes déborderont d'environ 40 microns. Des languettes aussi fines et présentant une telle étendue en débordement, sont fort susceptibles d'être brisées localement et d'être irrégulières.

Lors de l'étape suivante illustrée en figure 5, on casse complètement les languettes en débordement, par exemple en opérant par brossage et jet d'eau, ces opérations pouvant d'ailleurs être simultanées.

La figure 6 illustre l'étape suivante du procédé. On procède à une nouvelle attaque chimique du silicium pour approfondir le sillon d'une faible valeur, par exemple de 5 à 10 microns. Il se forme alors des languettes en débordement dont le surplomb est d'environ 3 à 5 microns.

Après cela, on procède à la vitrification des faces du sillon et d'une partie de la face supérieure de la plaquette, cette opération étant effectuée selon l'un ou l'autre des procédés de l'art antérieur exposés précédemment. Selon un avantage essentiel de la présente invention, et comme cela est représenté dans la vue de détail de la figure 7, le verre 40 lors de son frittage mouille le nitrure et vient adhérer contre la partie en saillie de la languette ou casquette de nitrure. On obtient ainsi un excellent recouvrement des coins ou arêtes de la face supérieure à la limite du sillon.

Comme on l'a vu précédemment, ce procédé se prête ensuite simplement aux étapes d'enlèvement de la portion de couche où des gouttelettes de verre qui pourraient être présentes sur la surface de la plaquette sans affecter la zone de silice protégeant l'affleurement de la jonction entre les couches 23 et 24.

On a décrit ci-dessus un mode de réalisation particulier du sillon. On notera que celui-ci peut être effectué non pas directement par attaque chimique, mais, surtout si l'on souhaite réaliser des sillons particulièrement profonds, l'attaque chimique peut être précédée d'une étape de découpe mécanique, par exemple au moyen d'une scie diamantée, ce qui évite l'étape de formation de l'ouverture 26 dans les couches 21 et 22.

De façon plus générale, la présente invention concerne un procédé de formation de sillons permettant une glassivation plus efficace de leurs arêtes en prévoyant qu'une couche de faible épaisseur d'un produit diélectrique fait saillie dans le prolongement et au-delà de la face supérieure de la plaquette à sillonner, la couche en saillie étant constituée d'un produit mouillant vis à vis du verre en cours de frittage.

La présente invention est susceptible de diverses variantes et généralisations incluses dans le domaine des revendications ci-après.

10

## REVENDICATIONS

1. Procédé de sillonnage et de passivation d'une plaquette de silicium, caractérisé en ce qu'il comprend les étapes suivantes :

- former sur la plaquette une couche mince de silice thermique d'une épaisseur comprise entre sensiblement 300 et 1000 Å;

- former sur cette couche de silice une couche de nitrure de silicium d'une épaisseur de 900 à 1500 Å;

- former des sillons dans la plaquette;

- enlever les parties de la couche de nitrure restant en surplomb au-dessus de ces sillons;

- procéder à une attaque chimique de courte durée pour approfondir les sillons et former en surplomb une casquette de nitrure de longueur choisie; et

- déposer une substance de glassivation dans le sillon et sur la couche de nitrure au moins au voisinage des bords du sillon, et la fritter.

2. Procédé selon la revendication 1 caractérisé en ce que l'étape de formation des sillons dans la plaquette comprend les étapes consistant à :

- ouvrir les couches de nitrure et de silice en des emplacements choisis; et

- former par attaque chimique des sillons dans la plaquette auxdits emplacements.

3. Procédé selon la revendication 1 caractérisé en ce que l'enlèvement des parties de la couche de nitrure restant en surplomb au-dessus des sillons est effectuée par brossage et projection d'eau.

4. Procédé selon l'une quelconque des revendications 1 à 3 caractérisé en ce que les casquettes de nitrure en surplomb ont une longueur comprise entre environ 3 et environ 5 microns.

5. Composant semiconducteur à base de silicium monocristallin dont la tranche est glassivée à partir

11

d'au moins l'une de ses faces, caractérisé en ce que, à l'intérieur de la glassivation, est comprise une languette de nitrure de silicium dans le prolongement de la face d'où part la glassivation et en débordement par rapport à cette face.

6. Composant selon la revendication 5, caractérisé en ce que la languette de nitrure de silicium a une longueur en débordement de l'ordre de 3 à 5 microns.

FIG_1

FIG_2-A

FIG_2-B

0028170

FIG_3

FIG_4

FIG_5

FIG_6

FIG_7

## DOCUMENTS CONSIDERES COMME PERTINENTS

| Catégorie | Citation du document avec indication, en cas de besoin, des parties pertinentes | Revendication concernée |
|---|---|---|
| | US - A - 3 735 483 (GENERAL ELECTRIC) <br> * Figures 1,4-6; colonne 14, lignes 2-8 * <br><br> -- | 1-3,5 |
| | US - A - 3 895 127 (RCA) <br> * Revendications 1,3,5; colonne 3, lignes 3-14 * <br><br> -- | 1-3,5 |
| | DE - A - 2 724 348 (DEUTSCHE ITT) <br> * Figure 1; revendications 1,4 * <br><br> -- | 1 |
| | FR - A - 2 099 527. (MOTOROLA) <br> * Figures 6-8; revendications 1,3 * <br><br> ---- | 1 |

**CLASSEMENT DE LA DEMANDE (Int. Cl. 3)**

H 01 L 21/56
23/28

**DOMAINES TECHNIQUES RECHERCHES (Int. Cl. 3)**

H 01 L 21/56
23/28

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 20-01-1981 | DE RAEVE |

**OEB Form 1503.1   06.78**